# EUROPÄISCHE PATENTSCHRIFT

(11) **EP 4 355 153 B1**
(45) Veröffentlichungstag und Bekanntmachung des Hinweises auf die Patenterteilung: **26.02.2025**
(21) Anmeldenummer: 21732060.5
(22) Anmeldetag: 14.06.2021
(51) Int. Cl.: A24F 40/40, A24F 40/51, A24F 40/90, A24F 40/42, A24F 40/60, A24F 40/10

(54) **ELEKTRISCHE ZIGARETTE**
ELECTRONIC CIGARETTE
CIGARETTE ÉLECTRONIQUE

(43) Veröffentlichungstag der Anmeldung: 24.04.2024
(73) Patentinhaber: CARNAULT AG, 4057 Basel (CH)
(72) Erfinder: SCHWITZER, Michael, 09244 Lichtenau (DE); BOCK, Daniel, 09111 Chemnitz (DE); KAISER, Tobias, 4057 Basel (CH)
(74) Vertreter: Schirbach, Marcel
(86) Internationale Anmeldenummer: PCT/EP2021/065981
(87) Internationale Veröffentlichungsnummer: WO 2021/254967

(56) Entgegenhaltungen:
- EP-A1- 3 240 442
- EP-A2- 2 477 514
- EP-A2- 3 369 328
- EP-B1- 2 477 514
- EP-B1- 3 240 442
- US-A1- 2017 000 190

## Beschreibung

### Gebiet der Erfindung

Die vorliegende Erfindung fällt in das Gebiet des täglichen Lebensbedarfs und betrifft eine elektrische Zigarette gemäss dem Oberbegriff des Anspruchs 1.

### Stand der Technik, technologischer Hintergrund der Erfindung

Herkömmliche elektrische Zigaretten sind handliche Geräte, welche unter Einsatz von elektrischer Energie aus einer Vorläuferzusammensetzung ein inhalierbares Aerosol erzeugen. Zu diesem Zweck verfügt jede elektrische Zigarette mindestens über die nachfolgenden Funktionselemente: eine Energiequelle, elektronische Steuerkomponenten, eine Vorläuferzusammensetzung und eine Aerosolisierungseinheit. Letztere kann aus einem Heizelement, z.B. einem Glühdraht oder einem Heizchip, oder einer anderweitigen Baugruppe bestehen, welche in der Lage ist, die Vorläuferzusammensetzung in ein Aerosol zu überführen, z.B. mithilfe eines Ultraschall-Zerstäubers, oder mittels einer Ein- oder Zweistoffzerstäuberdüse. Die Vorläuferzusammensetzung kann dabei einerseits aus einem Liquid bestehen oder andererseits Festbestandteile beinhalten, wie z. B. präparierte Tabakerzeugnisse (sogenannte Heat-not-Burn-Produkte).

Elektrische Zigaretten sind darauf ausgelegt, gleich traditionellen Tabakzigaretten verwendet zu werden. Ein Nutzungsszenario, wie es beim Konsum einer traditionellen Tabakzigarette die Regel ist und folglich bei elektrischen Zigaretten im Bereich des Erwartbaren liegt, bestünde darin, dass mehrmals hintereinander mit kurzen Pausen zwischen den einzelnen Zügen das durch die elektrische Zigarette erzeugte Aerosol inhaliert wird. Ein solcher Vorgang, wobei die elektrische Zigarette üblicherweise in der Hand gehalten, an den Mund geführt und schließlich das Aerosol in Form einer Art Nebel oder Dampf ein- und in Teilen wieder ausgeatmet wird, ist auch durch eine erwünschte Sicht- und Wahrnehmbarkeit gegenüber Außenstehenden beeinflusst. Das Rauchen traditioneller Tabakzigaretten wurde und wird in vielen Teilen der Welt massiv beworben. Dabei wurde und wird mitunter versucht, es mit positiven Werten, wie Geselligkeit, Authentizität und Freiheit in Verbindung zu bringen. Der globale Erfolg traditioneller Tabakzigaretten, welcher sich in der hohen Zahl an Konsumenten von mehr als einer Milliarde Menschen ausdrückt, könnte ein Zeichen dafür sein, dass dieser Versuch mindestens teilweise geglückt ist. So legt auch die Tatsache, dass das Rauchen von Tabakzigaretten extrem weit verbreitet ist, nicht jedoch die Verwendung von ähnlich wirkenden, oft günstigeren und in einigen Fällen weitaus weniger schädlichen nikotinhaltigen Produkten, wie z.B. Oraltabak, nahe, dass gerade die hohe Sicht- und Wahrnehmbarkeit des Rauchvorgangs und des Produkts einen maßgeblichen Einfluss auf dessen Erfolg hat beziehungsweise dessen Fähigkeit, mit positiven Werten verknüpft zu werden.

Diese Erwägungen lassen den Schluss zu, dass der Erfolg einer elektrischen Zigarette ebenfalls in hohem Maße von der Außenwahrnehmung des Produkts selbst und von der Außenwahrnehmung während der Verwendung des Produkts abhängig ist. Im gleichen Sinne liegt auch der Schluss nahe, dass das Design für die Frage mitentscheidend ist, inwiefern sich eine elektrische Zigarette mit eben jenen Werten glaubhaft verbinden lässt, welche der Tabakzigarette zu besagtem Erfolg verholfen haben. Dabei sei festzuhalten, dass diese bereits oben beschriebenen Werte mindestens insofern als zeitlos zu bezeichnen sind, da es sich für Menschen um fundamentale, in beinahe jeder Kultur ausgiebig und intensiv thematisierte Werte handelt, bei denen davon ausgegangen werden kann, dass sie auch in der Zukunft relevant sein werden. Das Produktdesign ist damit ein wesentliches Differenzierungsmerkmal sowohl gegenüber anderen elektrischen Zigaretten als auch gegenüber traditionellen Tabakzigaretten und kann unter Umständen das einzige Unterscheidungskriterium sein, welches nach außen hin sichtbar ist. Es kann folglich von erfolgsentscheidendem Vorteil sein, wenn sich eine elektrische Zigarette durch einen oder mehrere der folgenden Aspekte auszeichnet, namentlich eine hochwertige Materialwahl der nach außen hin sichtbaren Baugruppen, eine hohe Verarbeitungsqualität, eine hohe Lebensdauer, Möglichkeiten der Individualisierung des Außen-Designs, etwa durch eine Austauschbarkeit von Baugruppen, eine geringe Produktgröße, die einer angenehmen Handlichkeit bzw. Haptik und einer einfachen Handhabung entgegenkommt, und Dimensionen, welche der Form und Größe einer klassischen Tabakzigarette so nahe wie möglich kommen, da man davon ausgehen kann, dass viele Menschen an die Form und Größe klassischer Tabakzigaretten gewöhnt sind und zudem an deren Gewicht. Ferner sind heute Aspekte wie Umweltfreundlichkeit, Abfallminimierung, Recyclingfähigkeit und die Abfalltrennung von Materialien von Bedeutung. Selbiges gilt hinsichtlich der Materialwahl. Ausgewählte Materialien, wie z. B. Holz oder Ebonit sind Rauchern aus zigarettenverwandten Produkten wie Tabakpfeifen wohl bekannt, wodurch der Rückgriff auf solche Materialien bei elektrischen Zigaretten gleichfalls eine Vertrautheit bei Rauchern hervorzurufen vermögen könnte.

Ferner soll in der elektrischen Zigarette eine Steuerelektronik ein zuverlässiges und sicheres Funktionieren der Aerosolerzeugung gewährleisten und gegebenenfalls erweiterte Funktionen umfassen, wie beispielsweise die Möglichkeit einer Bluetooth-Anbindung an ein Smartphone oder einer Authentifizierung des Verbrauchsguts in einer sogenannten Cartridge bzw. Patrone und ferner eine Mengenkontrolle; dabei geht der erweiterte Funktionsumfang unmittelbar mit einem erhöhten Platzbedarf für elektronische Komponenten bzw. für elektronische Bauelemente einher, z.B. für komplexere Schaltungsstrukturen in und um integrierten Schaltkreisen [IC - integrated circuits]. Zudem umfasst eine solche Steuerelektronik ein Einschaltelement in Form eines Schalters, Tasters oder Sensors, welcher einen Luftzug des Kunden zu registrieren vermag (z. B. Drucksensor, Luftflusssensor, Temperatursensor), sowie gegebenenfalls Anzeigeelemente, wie z. B. eine LED, und Komponenten zur Auswertung. Des Weiteren ist die Modularität von elektrischen Zigaretten zwecks Austausches einzelner Komponenten im Fall von Weiterentwicklungen und Verbesserungen oder im Schadensfall von Vorteil. Hierzu sind diverse Schnittstellen und Kontakte erforderlich, welche einen zusätzlichen Platzbedarf erforderlich machen können.

Bei einer Akkuzelle ist als Energiequelle eine hohe abrufbare Stromstärke und eine möglichst hohe nutzbare Kapazität vorteilhaft, wobei damit die positive Korrelation zwischen Akkukapazität und maximalem Entladestrom einhergeht, sowie der meist unvorteilhaften positiven Korrelation zwischen Kapazität, maximalem Entladestrom und einem entsprechend grossen Volumen bzw. einer entsprechend grossen Masse einer solchen Akkuzelle.

Selbstverständlich bleiben mit Blick auf geringe Produktionskosten wirtschaftliche Aspekte nicht ausser Acht, die auf eine entsprechend einfache Montage, günstige Komponenten, möglichst kostengünstige und damit einhergehende, optimierte Baugrösse oder einen hohen Grad an Automatisierung abstellen.

Einige der oben genannten Anforderungen an elektrische Zigaretten stehen zueinander in einem Zielkonflikt und bedürfen somit ein Abwägen zwischen unbedingt zu erfüllenden Vorteilen und damit andererseits einhergehenden zweitrangigen Nachteilen.

So führt beispielsweise die Verwendung natürlicher Materialien wie z. B. Holz oder Ebonit dazu, dass eine gewisse der Stabilität geschuldete Mindestwandstärke nicht unterschritten werden kann, die grösser ausfällt als etwa bei Edelstahl oder anderweitigen Metallen und Legierungen, so dass z. B. Hülsen aus Holz oder Ebonit mit einem erhöhten Platzbedarf einhergehen. Um der Form und Grösse einer Tabakzigarette möglichst treu bleiben zu können und gleichsam eine technisch fortschrittliche elektrische Zigarette realisieren zu können, macht dies eine platzsparende Konstruktion unumgänglich.

Des Weiteren hat zum Beispiel eine kreiszylindrische Gehäuseform zur Folge, dass die Batteriezelle, um optimal in diese Form hineinpassen zu können, ebenfalls kreiszylindrisch sein muss. Allerdings gilt zumindest für kleine Zellgrössen, dass sich bei gleichem Volumen quaderförmige Akkuzellen mit einer höheren Kapazität realisieren lassen als kreiszylindrische Akkuzellen. Dies liegt im grundsätzlichen Lagenaufbau von Akkuzellen begründet. Bei einer runden Zelle werden die Elektroden- und Separator-Lagen zumeist aufgerollt, wodurch aufgrund des beschränkten Krümmungswinkels der verwendeten Lagen mittig ein ungenutzter Hohlraum entsteht. Umso wichtiger ist eine effiziente Bauraumnutzung in einem kreiszylindrischen Gehäuse. Ein quaderförmiger Gehäuseaufbau kommt zusätzlich auch der Bauweise von Leiterplatten entgegen. Eine flache und rechteckige Leiterplatten-Form lässt sich ohne Einbussen in Sachen Baugrösse oder Funktionalität leichter realisieren und kann zur gleichen Zeit platzeffizient in ein quaderförmiges Gehäuse integriert werden. Die elektronischen Komponenten, mit welchen die Leiterplatte einer Kontrolleinheit bestückt wird, sind oftmals selbst rechteckig, entsprechend lassen sie sich auf einer rechteckigen Leiterplatten-Fläche effizienter anordnen als auf einer runden. Ein quaderförmiges Gehäuse kommt somit der Bauform von Akkuzellen und Leiterplatten eher entgegen als es bei einem kreiszylindrischen der Fall wäre und würde beispielsweise den Zielkonflikt kleine Produktgrösse, möglichst leistungsfähige Akkuzelle und gute Platzausnutzung der Leiterplatte vereinfachen. In der Folge entfernt man sich aber von dem Ziel der Ähnlichkeit zur Tabakzigarette.

Unter den Aspekten der Nachhaltigkeit und Wirtschaftlichkeit macht ein Einsatz hochwertiger Materialien oder das Investieren in eine hohe Verarbeitungsqualität nur dann Sinn, wenn die entsprechenden Bauteile eine gewisse Haltbarkeit aufweisen. Folglich wäre es von Nachteil, wenn die Lebensdauer einer Batteriehülse, welche im zusammengebauten Zustand der elektrischen Zigarette den größten Teil der sichtbaren Fläche einnimmt und ein zentrales Design-Objekt darstellt, an die vergleichsweise begrenzte Lebensdauer der darin angeordneten Akkuzelle geknüpft wäre, wenn beide Teile fix miteinander verbunden wären. Um eine hohe Verarbeitungsqualität und einen Einsatz hochwertiger Materialien im Besonderen im Bereich der Batteriehülse auf sinnvolle Weise nachhaltig und wirtschaftlich anwendbar machen zu können, ist ein modular trennbarer Aufbau der Steuerelektronik bzw. Kontrolleinheit, der Batteriezelle und der Batteriehülse eine Voraussetzung. Ein hoher Grad an Modularität steht hier regelmässig im Widerspruch zu einer geringen Produktgröße, da die einzelnen Teile über trennbare mechanische und elektrische Verbindungen verfügen müssen, welche generell zusätzlichen Platz einnehmen. Außerdem, da höhere Anforderungen an die Konstruktion gestellt werden, kann diese komplexer werden: es kann sein, dass mehr und/oder komplexere Bauteile benötigt werden oder es eine größere Zahl an Arbeitsschritten für die Fertigung braucht, was negative Auswirkungen auf die Endmontage und die Produktionskosten hätte.

Möglichst leistungsstarke Akkuzellen stehen einer möglichst hohen Funktionalität der Steuerelektronik und einer geringen Produktgröße entgegen. Eine einfache Montage der elektrischen Zigarette kann im Widerspruch zu einer immer komplexer werdenden Steuerelektronik stehen, welche zuweilen den Einsatz flexibler Leiterplatten oder diverser Verkabelungen und zusätzlicher Teile zum Verbinden der Leiterplatte mit dem Gehäuse, zum Beispiel Spritzgussteile etc. zur Folge hat.

Eine einfache technische Bedienung kann ebenfalls negative Auswirkungen auf den Platzbedarf und die Produktgröße haben, dabei ist zudem erstrebenswert, dass die elektrische Zigarette während der Aufladung des Akkus in einem zusammengebauten und quasi funktionsfähigen Zustand verbleibt. Eine solche Ladbarkeit nimmt dabei möglicherweise zusätzlichen Raum ein im Gegensatz zu einem permanenten Verschluss, der keine weiteren Funktionen abbildet, etwa weil zusätzliche Verkabelungen erforderlich werden können. Ebenso können gesteigerte Anforderungen an die Funktionalität oder an die elektrische Konstruktion zu einem erhöhten Platzbedarf führen. Die Erkennung von Änderungen des Luftdruckes oder Luftdurchsatzes beim Rauchvorgang, so dass die elektrische Zigarette gleich einer Tabakzigarette benutzt werden kann, macht beispielsweise ein Luftflussmanagement erforderlich. Oftmals wird dabei auf zusätzliche Bauteile nebst einem Drucksensor zurückgegriffen.

Aus der Druckschrift WO 2019/104441 A1 ist eine elektrische Zigarette bekannt, die zur Druckmessung einen Luftmassenmesser verwendet. Der Luftmassenmesser hat vorliegend einen stromaufwärtigen Eingangsanschluss und einen stromabwärtigen Eingangsanschluss. Der Luftmassenmesser kann ein Drucksensorelement enthalten, das zwischen dem stromaufwärtigen Anschluss und dem stromabwärtigen Anschluss angeordnet ist. Das Drucksensorelement kann die Luftmasse bestimmen, die an der stromaufwärtigen Öffnung und der stromabwärtigen Öffnung vorbeigezogen wird, indem es die Druckdifferenz zwischen der stromaufwärtigen Öffnung und der stromabwärtigen Öffnung bestimmt. In den gleichen Fällen kann ein thermisches Hitzdrahtanemometer oder ein Festkörper-Hitzdraht-Luftmassensensor für den Luftmassensensor verwendet werden. In anderen Fällen können einzelne barometrische Drucksensoren an jedem der stromaufwärts gelegenen Anschlüsse und stromabwärts gelegenen Anschlüsse vorgesehen werden. Eine Differenz zwischen den barometrischen Drucksensoren -die sich aus dem Druckabfall-Element innerhalb des Fluidkanals ergibt- kann zur Bestimmung des Luftmassenstroms verwendet werden.

Die Druckschrift EP 3 369 328 A2 offenbart ein Ladesystem für elektronische Zigaretten, umfassend eine elektronische Zigarette mit einem ersten Satz elektrischer Kontakte, einem Zerstäuber und einer wiederaufladbaren Batterie zum Betreiben des Zerstäubers. Das System umfasst ferner eine Elektrodenbaugruppe, die mit einer Stromquelle verbunden werden kann und einen zweiten Satz elektrischer Kontakte aufweist, die so angeordnet sind, dass sie mit dem ersten Satz elektrischer Kontakte zusammenpassen, woraufhin die elektronische Zigarette über die Elektrodenbaugruppe Strom erhält, um die Batterie wieder aufzuladen, während sie für die Verwendung durch einen Raucher betriebsbereit bleibt. Elektrische Schaltkreise, die mit dem ersten Satz elektrischer Kontakte verbunden sind, umfassen einen ersten Schaltkreis zur Versorgung des Zerstäubers mit Batteriestrom und einen zweiten Schaltkreis zur Versorgung der Batterie mit Strom von einem Batterieladegerät zum Aufladen der Batterie, wobei der erste Schaltkreis mit dem zweiten Schaltkreis zusammenwirkt, um den Stromfluss über die Elektrodenanordnung zur Batterie zu unterbrechen, wenn der Zerstäuber aktiviert ist, und um den Stromfluss wieder aufzunehmen, wenn der Zerstäuber nicht mehr aktiviert ist.

Die Druckschrift EP 2 477 514 A2 eine elektrische Zigarette mit einem Inhalationsdetektor und einer Schaltung zur Erzeugung eines Raucheffekts. Der Inhalationsdetektor umfasst einen Luftstromsensor, der so beschaffen ist, dass er die Richtung und die Geschwindigkeit des Luftstroms durch die Rauchvorrichtung erfasst, und die Schaltung zur Erzeugung des Raucheffekts ist so beschaffen, dass sie die Schaltung zur Erzeugung des Raucheffekts betätigt, um einen Raucheffekt zu erzeugen, wenn die Richtung des Luftstroms dem Inhalieren durch die Vorrichtung entspricht und die Luftstromgeschwindigkeit einen vorgegebenen Schwellenwert erreicht. Ein solcher elektronischer Rauch mindert das Problem der unbeabsichtigten Auslösung aufgrund von Umgebungsvibrationen oder -lärm oder spielenden Kindern, die in das Gerät pusten.

### Darstellung der Erfindung

Es ist deshalb Aufgabe der vorliegenden Erfindung, eine elektrische Zigarette dahingehend weiterzuentwickeln, dass unter Ausnutzung sämtlicher Vorteile bekannter elektrischer Zigaretten (mit bzw. ohne Schadstoffe, heilende bzw. medizinische Zusätze, Entwöhnungsmittel, reines Dampfen ohne Zusatzstoffe...), ein vereinfachter Aufbau mit einem hohen Mass an Modularität ermöglicht wird und gegenüber herkömmlichen, elektrischen Zigaretten eine kleinere Bauform ermöglicht wird und eine erweiterte, sichere und langlebige Funktionalität, insbesondere auch mit Blick auf das Luftflussmanagement, für das oftmals auf einen Drucksensor abgestellt wird.

Die der Erfindung für die elektrische Zigarette zugrundeliegende Aufgabe wird gelöst durch die Merkmale des Anspruchs 1; die diesen Erfindungsgedanken weiterbildenden Merkmale sind jeweils Gegenstand der Unteransprüche 2 bis 10.

Mit Vorteil weist die elektrische Zigarette gemäss der vorliegenden Erfindung entlang einer zentralen Z-Achse von unten nach oben eine Patroneneinheit und eine daran lösbar angeordnete Kontrolleinheit auf, wobei die elektrische Zigarette unten an einem ersten Ende mit einem Mundstückende und oben an einem zweiten Ende mit einer Ladespitze abschliesst, und wobei diese elektrische Zigarette über deren gesamte Längenausdehnung eine zylindrische oder mehreckige Querschnittsfläche aufweist und einen ersten und/oder einen zweiten und/oder einen dritten Steuerelementkörper mit einem jeweiligen Körperdurchmesser senkrecht zur zentralen Z-Achse umfasst und dabei dieser jeweilige Körperdurchmesser derart gewählt ist, dass der jeweilige Steuerelementkörper im Innern mit der elektrischen Zigarette einen Passsitz ausbildet und wobei der jeweilige Steuerelementkörper ferner als eine Leiterplattenstruktur mit mindestens einer mittels einer Isolationsfüllung isolierten Leiterplatte ausgebildet ist, die quer zur Z-Achse ausgerichtet ist, und wobei auf dieser Leiterplatte mindestens ein Drucksensor angeordnet, der mit einer Kavität in der Leiterplattenstruktur wirkverbunden ist.

Gegenüber dem Stand der Technik hebt sich die erfindungsgemässe elektrische Zigarette mit ihrer zylindrischen oder mehreckigen Querschnittsfläche und ihrem kompakten Aufbau und insbesondere mit ihrem kompakt und geschützt angeordnetem Drucksensor vom Stand der Technik ab; ferner ermöglicht die Anordnung des Steuerelementkörpers mittels Passsitz in der elektrischen Zigarette eine wesentlich verbesserte Raumnutzung innerhalb dieser elektrischen Zigarette und zudem einen wesentlich höheren Modularitätsgrad, da jeder Steuerelementkörper bei Bedarf oder auf Wunsch zerstörungsfrei austauschbar ausgebildet ist.

Bei einer besonders vorteilhaften Ausführungsform der Erfindung ist der Steuerelementkörper als eine Steuereinheit ausgebildet, die zwischen der Patroneneinheit und der Kontrolleinheit mit dem Passsitz angeordnet ist und die Kontrolleinheit zu dieser Patroneneinheit hin abschliesst. Diese Anordnung der Steuereinheit ist wegen ihres zentralen Sitzes zwischen der Kontrolleinheit und der Patroneneinheit vorteilhaft, da somit unmittelbar auf beide Einheiten, namentlich die Kontrolleinheit und die Patroneneinheit, steuernd bzw. regelnd eingegriffen werden kann.

Eine besonders vorteilhafte Ausführungsform der Erfindung zeichnet sich dadurch aus, dass der mindestens eine Drucksensor mit der mindestens einen Leiterplatte als eine in die Leiterplattenstruktur eingebettete, integrierte elektronische Komponente ausgebildet ist. Der Drucksensor kann ferner mit Vorteil vollständig von der Kavität umgeben sein, mit Ausnahme seiner direkten, auch elektrischen Leiterplattenverbindung; bei dieser Ausführungsform kann die Kavität zum einen unmittelbar mittels der Isolationsfüllung nach aussen verschlossen sein, oder aber es kann der von der Kavität umgebene Drucksensor zunächst von einer Kappe überdeckt sein, wobei nach aussen hin diese Kappe mittels der Isolationsfüllung fixiert werden kann. Der Vorteil bei der Verwendung der Kappe bzw. einer Haube besteht darin, dass diese im Vergleich zur Isolationsfüllung formstabiler ausführbar ist und die Kavität somit definiert begrenzbar ist. Es kann ferner vorteilhaft sein, wenn bei einer weiteren Ausführungsform der Erfindung der Drucksensor neben der Kavität partiell von der Isolationsfüllung umgeben ist; hiermit ist eine kompakte, stabile und feste Verbindung zwischen der Leiterplatte und dem Drucksensor gegeben. Bei einer weiteren vorteilhaften Ausführungsform der Erfindung ist vorgesehen, dass die Kavität im Drucksensor intrinsisch ausgeführt ist bzw. selbst darin angeordnet ist und dieser Drucksensor mitsamt Kavität in die Leiterplattenstruktur integriert ist.

Bei der Herstellung der Kavität bieten sich verschiedene Verfahren des Standes der Technik an. Vorliegend wird die Leiterplattenstruktur geschlossen mit gegebenenfalls allen innenliegenden, eingebetteten, integrierten elektronischen Komponenten hergestellt und anschliessend wird die Öffnung zur Kavität eingebracht, damit der Drucksensor in der Kavität durch diese Öffnung mit Druckänderungen im Luftstrom der elektrischen Zigarette in Wirkverbindung treten kann. Zur Erstellung der Öffnung kann beispielsweise auf klassische Bearbeitungsverfahren für die Leiterplattenmaterialien bzw. Isolationsmaterialien, wie z.B. mechanisches Bohren, Laserbohren, Ätzen, usw., zurückgegriffen werden.

Mit Blick auf das gewünschte, hohe Mass an Modularität ist es besonders vorteilhaft, wenn der zwischen der elektrischen Zigarette ausgebildete Passsitz des Steuerelementkörpers als eine Spielpassung ausgebildet ist, wobei der Steuerelementkörper gerade noch leicht verschiebbar angeordnet ist, oder wenn der mit der elektrischen Zigarette ausgebildete Passsitz des Steuerelementkörpers als eine Übergangspassung ausgebildet ist, wobei der Steuerelementkörper mit geringem Druck verschiebbar angeordnet ist. Jedenfalls ermöglicht die Anordnung mit Passsitz zumindest eine möglichst exakte Positionierung jedes Steuerelementkörpers in der elektrischen Zigarette bei kleinstem Raumbedarf und im Falle der Übergangspassung zudem ein angestrebtes Mass an Fixierbarkeit.

Selbstverständlich ist es im Rahmen der vorliegenden Erfindung auch denkbar, den mindestens einen Drucksensor oder einen weiteren Drucksensor in der Leiterplattenstruktur der Ladespitzensteuerung und/oder der Patronensteuerung zu integrieren.

Weitere vorteilhafte Ausführungsformen werden anhand der nachfolgenden Figuren im Zusammenhang mit der detaillierten Erfindungsbeschreibung hervorgehoben.

### Kurze Beschreibung der Figuren

Im Folgenden wird die Erfindung anhand von Figuren beispielhaft erläutert. Gleiche Gegenstände sind in den Figuren grundsätzlich mit gleichen Bezugszeichen versehen. An dieser Stelle wird darauf hingewiesen, dass die Figuren keinerlei einschränkende Wirkung auf den Erfindungsgegenstand haben, sondern lediglich mögliche Ausführungsformen des Erfindungsgedankens darstellen.

### Es zeigen rein schematisch die

Fig. 1 eine Längsschnittdarstellung einer elektrischen Zigarette gemäss der Erfindung mit einer zentralen Z-Achse zwecks einer einfachen Beschreibung bei der Verortung einzelner Elemente der elektrischen Zigarette mittels der hier auch teilweise in den Figuren verwendeten Begriffe, «oben», «unten», «nach oben hin», «nach unten hin», «oberer Abschluss», «unterer Abschluss», «Oberseite», «Unterseite»; zudem ist eine vergrösserte Längsschnittdarstellung einer Patroneneinheit dieser elektrischen Zigarette gezeigt;
Fig. 2 eine Querschnittdarstellung eines Steuerelementkörpers der elektrischen Zigarette am Beispiel einer Steuereinheit, welche als Leiterplattenstruktur ausgebildet ist;
Fig. 3 eine Ausführungsform der Querschnittdarstellung des Steuerelementkörpers der elektrischen Zigarette am Beispiel der Steuereinheit;
Fig. 4 eine weitere Ausführungsform der Querschnittdarstellung des Steuerelementkörpers der elektrischen Zigarette am Beispiel der Steuereinheit; und
Fig. 5 noch eine weitere Ausführungsform der Querschnittdarstellung des Steuerelementkörpers der elektrischen Zigarette am Beispiel der Steuereinheit, welche als Leiterplattenstruktur ausgebildet ist.

### Wege zur Ausführung der Erfindung

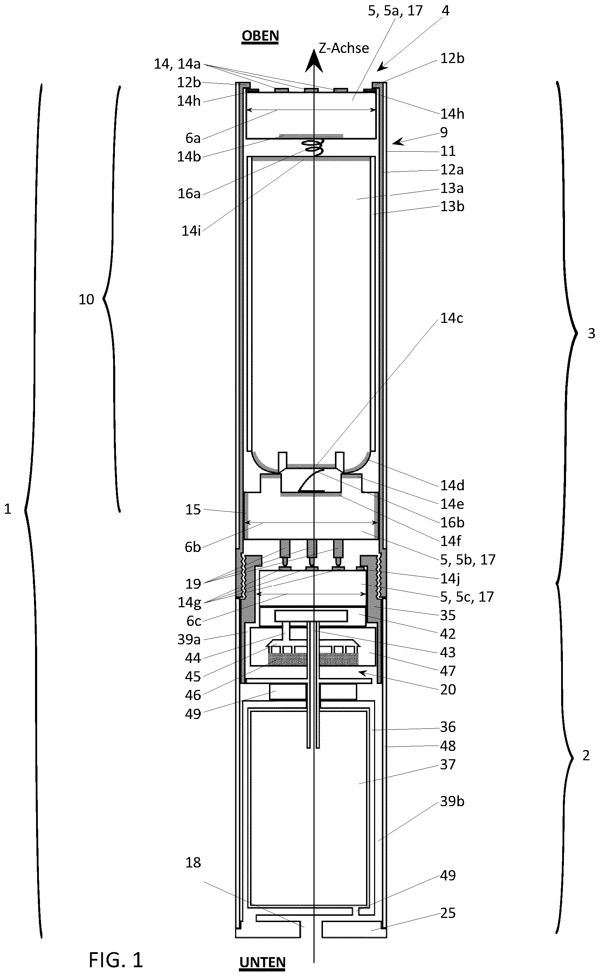

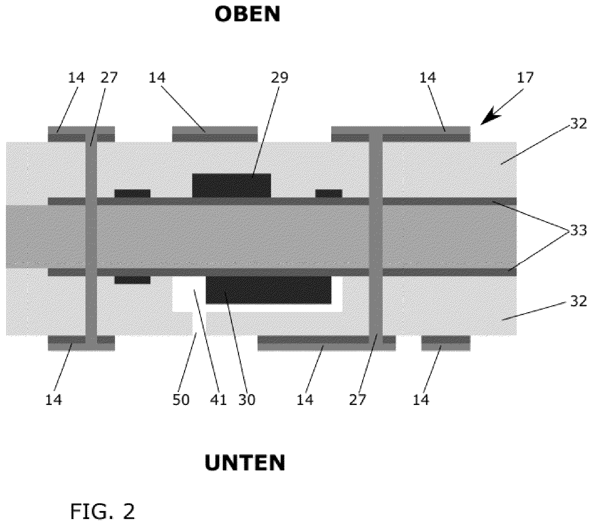

Fig. 1 zeigt eine Längsschnittdarstellung einer erfindungsgemässen elektrischen Zigarette 1. Hier dargestellt ist die elektrische Zigarette 1 mit einer zentralen Z-Achse mit einer Pfeilspitze am oberen Ende zwecks einer einfachen Beschreibung bei der Verortung einzelner Bestandteile der elektrischen Zigarette 1 mittels der hier auch teilweise in den Figuren verwendeten Begriffe, «oben», «unten», «nach oben hin», «nach unten hin», «oberer Abschluss», «unterer Abschluss», «Oberseite», «Unterseite», usw. Vorliegend umfasst die erfindungsgemässe elektrische Zigarette 1 von unten nach oben eine Patroneneinheit 2 und eine daran lösbar angeordnete Kontrolleinheit 3, wobei hieran an einem der Patroneneinheit 2 abgewandten Ende dieser elektrischen Zigarette 1 die Ladespitze 4 angeordnet ist. Diese Ladespitze 4 weist eine Anzahl elektrischer Kontaktflächen 14, 14a auf, die zwecks einer Aufladung der elektrischen Zigarette 1 und/oder zwecks eines Datenaustauschs mit der elektrischen Zigarette 1 kontaktierbar sind. Die Ladespitze 4 umfasst einen Steuerelementkörper 5, der hier als eine Ladespitzensteuerung 5a mit einem Körperdurchmesser 6a senkrecht zur zentralen Z-Achse ausgebildet ist, wobei dieser Körperdurchmesser 6a derart gewählt ist, dass die Ladespitzensteuerung 5a mit der elektrischen Zigarette 1 einen Passsitz ausbildet. Mit dieser Art der Ausgestaltung wird insbesondere mit Blick auf den Körperdurchmesser 6a die grösstmögliche Raumausnutzung bei kleinstem Raumbedarf der Ladespitzensteuerung 5a ermöglicht, die zudem nach oben bzw. nach unten mit den elektrischen Kontaktflächen 14, 14a, 14b ausgestattet ist. Die Ladespitzensteuerung 5a ist vorliegend als eine Leiterplattenstruktur 17 ausgebildet, auf die nachfolgend und insbesondere unter Zuhilfenahme der Fig. 2 bis 5 einzugehen sein wird. Die Ladespitze 4 ist einer Batterieeinheit 10 zugeordnet, die in einer Batteriehülse 9 eine Batterie 13a mit einer umgebenden Batterieisolierung 13b aufweist, welche Batterie 13a nach oben zur Ladespitzensteuerung 5a bzw. zu deren unterer elektrischer Kontaktfläche 14b eine elektrische Kontaktfläche 14i aufweist, wobei zwischen diesen beiden elektrischen Kontaktflächen 14b, 14i ein verbindender Federkontakt 16a angeordnet ist.

Die Batteriehülse 9 weist eine leitfähige Innenröhre 12a auf und ist nach aussen hin von einer isolierenden Aussenröhre 11 umgeben. Am unteren Ende ist die leitfähige Innenröhre 12a mit einem als Steuereinheit 5b ausgebildeten Steuerelementkörper 5 verschlossen, welche Steuereinheit 5b nach oben Kontaktflächen 14f bzw. 14e aufweist, die mit unteren Kontaktflächen 14c, 14d der Batterie 13a in Verbindung stehen, wobei ein Federkontakt 16b die Kontaktflächen 14c und 14f brückt. Der Steuerelementkörper 5 der Steuereinheit 5b weist einen Körperdurchmesser 6b auf, der mit der elektrischen Zigarette 1 ebenfalls einen Passsitz ausbildet.

Die Steuereinheit 5b ist am unteren Ende mit einer Anzahl Kontaktstiften 19 ausgestattet, die mit Kontaktflächen 14g der Patroneneinheit 2 elektrisch wirkverbunden sind. Dabei ist mit Vorteil die Steuereinheit 5b ebenfalls wie die Ladespitzensteuerung 5a als eine Leiterplattenstruktur 17 ausgestaltet, auf die noch einzugehen sein wird. Von besonderem Vorteil ist, dass die Ladespitzensteuerung 5a über die leitfähige Innenröhre 12a der Batteriehülse 9 und mittels eines Mantelflächenkontakts 15 der Steuereinheit 5b bzw. zu einem weiteren Steuerelementkörper 5 in der Patroneneinheit 2 elektrisch verbunden ist, wobei dieser weitere Steuerelementkörper 5 hier als eine Patronensteuerung 5c ausgebildet ist. Mittels dieser elektrischen Wirkverbindungen kann über die Ladespitzensteuerung 5a, die Steuereinheit 5b bzw. die Patronensteuerung 5c neben der Aufladung der elektrischen Zigarette 1 auch ein durchgängiger Datenaustausch stattfinden, der zum Beispiel Schaltbefehle mitumfassen kann, oder aber Parametrierdaten oder Programmierdaten. Der Steuerelementkörper 5 der Patroneneinheit 5c weist hier einen Körperdurchmesser 6c auf, der mit der elektrischen Zigarette 1 auch einen Passsitz ausbildet, hier vorliegend mit einem Patronenabschluss 35.

In der hier vorliegenden Ausführungsform der Erfindung umfasst die Patroneneinheit 2 ein Reservoirgehäuse 36, welches nach oben mit dem Patronenabschluss 35 und darin angeordneter Patronensteuerung 5c versehen ist und mit einer Aerosolvorläuferzusammensetzung 37 befüllt ist; nach unten verschliesst ein Mundstückende 25 mit einer Mundstücköffnung 18 das Reservoirgehäuse 36.

Die mit Passsitz positionierten Steuerelementkörper 5, namentlich die Ladespitzensteuerung 5a, die Steuereinheit 5b und die Patronensteuerung 5c, sind wahlweise auf zwei unterschiedliche Arten in der elektrischen Zigarette 1 anordenbar, zum einen mit einer sogenannten Übergangspassung und zum anderen mit einer Spielpassung. Vorliegend ist die Steuereinheit 5b mit deren Mantelflächenkontakt 15 in der Innenröhre 12a mittels einer Übergangspassung fixiert und somit darin nur mit geringem Druck verschiebbar, wohingegen die Ladespitzensteuerung 5a, die sich nach oben gegen einen Flansch 12b abstützt, mit der Innenröhre 12a eine Spielpassung ausbildet, und demzufolge leicht verschiebbar darin angeordnet ist.

Vorliegend umfasst die Patroneneinheit 2 neben der Patronensteuerung 5c nach unten eine Mikropumpe 42 und in der Folge einen Heizchip 47. Die Mikropumpe 42 bedient sich beispielsweise über eine Hohlnadel 43 aus einem Reservoirgehäuse 36 der Aerosolvorläuferzusammensetzung 37. Diese Patroneneinheit 2 umfasst beispielhaft zwei Teilegruppen, wobei die eine Teilegruppe lösbar an der elektrischen Zigarette 1 angeordnet ist und dort auch verbleibt und die andere Teilegruppe als Verbrauchsgut nach Konsum zum Austauschen ausgebildet ist. Die erste Teilegruppe, die an der elektrischen Zigarette 1 auch nach deren Nutzung verbleibt, umfasst den Patronenabschluss 35 mit der Patronensteuerung 5c, der Mikropumpe 42 und dem Heizchip 47 umgeben von der Patronenhülse 48 und die Nadel 43; die zweite Teilegruppe umfasst im Wesentlichen das in der Patronenhülse 48 eingesetzte Reservoirgehäuse 36 mit der Aerosolvorläuferzusammensetzung 37 und dem Mundstückende 25. Nach der Nutzung der elektrischen Zigarette 1 wird lediglich die zweite Teilegruppe als eine Einheit ausgewechselt, wobei nach dem Einsetzen in die Patronenhülse 48 die Aerosolvorläuferzusammensetzung 37 durch diese Nadel 43 von der Mikropumpe 42 angesaugt werden kann, um anschliessend über einen Zuführer 44 zu einem Verteiler 45 und abschliessend zu einem Verteilersubstrat 46 im Heizchip 47 weitergeleitet zu werden. Luft, die aus einem Luftkanal 39a zu einer Aerosolisierungszone 20 strömt, wird dort mit einem Aerosol aus der Aerosolvorläuferzusammensetzung 37 über den Luftkanal 39b einem Konsumenten an der Mundstücköffnung 18 bereitgestellt.

Wie bereits oben angesprochen, kann die Ladespitzensteuerung 5a, die Steuereinheit 5b und die Patronensteuerung 5c vorteilhafterweise als eine Leiterplattenstruktur 17 ausgebildet sein, wie sie in den Fig. 2 bis 5 näher gezeigt sind. Diese Leiterplattenstruktur 17 kann eine oder mehrere der nachfolgend gelisteten Funktionen der elektrischen Zigarette 1 aufweisen, namentlich eine Luftmengenmessung, eine Restmengenbestimmung für eine Aerosolvorläuferzusammensetzung 37, eine Ladezustandsbestimmung der Batterie 13a, eine Authentifizierungsvorrichtung oder eine Kommunikationseinrichtung (RFID, Bluetooth,...), gegebenenfalls für einen Datenaustausch mit einem Smartphone oder einer Smartwatch, wobei diese Funktionsliste als nicht abgeschlossen zu betrachten ist.

Fig. 2 zeigt nun eine beispielhafte Ausführungsform der Leiterplattenstruktur 17 der Steuereinheit 5b (Fig. 1), mit mehreren elektrischen Kontaktflächen 14 an der Oberseite bzw. an der Unterseite derselben; der Einfachheit halber sind alle Kontaktflächen -nicht wie in der Fig. 1 gezeigt- hier lediglich mit einem allgemeinen Bezugszeichen "14" versehen. Die hier vorliegende Leiterplattenstruktur 17 umfasst ebenfalls stark vereinfacht eine Anzahl von Leiterbahnen bzw. Durchkontaktierungen 27 sowie eine Anzahl integrierter Strukturen wie einen Mikrocontroller 29 und einen Drucksensor 30, welche auf mittels Isolationsfüllungen 32 voneinander isoliert ausgebildeten Leiterplatten 33 angeordnet sind. Mittels einer solchen Leiterplattenstruktur 17 sind eine Vielzahl von Funktionen der elektrischen Zigarette abbildbar, wobei gegebenenfalls weitere Strukturen ergänzt werden können oder weggelassen werden können. Ohne den Erfindungsgedanken zu verlassen ist es selbstverständlich auch denkbar, dass weitere Funktionen in dieser Leiterplattenstruktur 17 integriert werden, die hier nicht explizit genannt sind.

Vorliegend offenbart Fig. 2 in einer stark vergrösserten Schnittdarstellung eine mögliche Ausführungsform für die Leiterplattenstruktur 17. In ihrer einfachsten Form umfasst diese Leiterplattenstruktur 17 mindestens eine Leiterplatte 33, die mit einem Drucksensor 30 und einem Mikrocontroller 29 als integrierte Bauelemente ausgestattet ist. Es ist hier ein beispielhafter Aufbau auf Basis eingebetteter elektronischer Bauelemente dargestellt. Die später innenliegenden Bauelemente werden in dieser hier dargestellten Einbett-Technologievariante mittels eines Lötverfahrens auf die jeweilige, z.B. durch Ätzen strukturierte Kupferlage aufgelötet und im weiteren Leiterplatten-Fertigungsprozess durch Decklagen aus einer Isolationsfüllung bzw. aus Leiterplattenmaterial 32 (Prepregs) abgedeckt. Die Kupferlagen, auf die die Bauelemente gelötet werden, können entweder einzelne Folien oder wie im dargestellten Fall Bestandteil von vorbereiteten Zwei- oder Mehrlagen-Leiterplatten, bestehend aus mindestens einem Isolator, z.B. aus einem gehärteten Prepreg 32 und zwei aufgepressten Kupferlagen, sein. Abhängig von der Konstruktion und der Materialwahl wird z.B. das Harz in den Decklagen-Materialien während des nachfolgenden Leiterplatten-Pressprozesses zur Verfüllung von Freiräumen im Umfeld der eingebetteten Bauelemente genutzt.

Es sind weitere Einbett-Technologien verfügbar, die auch die Verarbeitung von nichtgehäusten aktiven elektronischen Komponenten, wie z.B. Mikrocontroller oder ASICs, ohne einen extra Lötprozess ermöglichen. Bei diesen Technologien werden für die Bauteilkontaktierung der später innenliegenden elektronischen Bauteile Standardverfahren aus der Leiterplattenindustrie, z.B. Mikrobohrungen (HDI-Technologie, Microvias) und Galvanik, genutzt. Der grundsätzliche Aufbau mit eingebetteten Bauelementen bleibt aber unabhängig von der gewählten Embedded-Variante weitgehend gleich. Auch mit den 3D-Druck-/Additivverfahren, z.B. auf Pasten-/Lackbasis mit Trocknung bzw. Aushärtung mit UV-Licht, lassen sich Mehrlagenleiterplatten mit eingebetteten Bauelementen herstellen.

Neben der Einbettung elektronischer Bauteile ermöglicht die Nutzung der Grossserien-tauglichen Leiterplattentechnologie auch eine komplexe 3D-Strukturierung der entstehenden Baugruppe mit Standardbearbeitungsverfahren bei gleichzeitig hoher Genauigkeit bzw. mit geringen Toleranzen. Dabei sind mechanische Führungen und zusätzliche äussere Kontaktelemente sehr leicht in abschliessenden Leiterplattenprozessen realisierbar.

Die verschiedenen Ebenen der Mehrlagenleiterplatte mit eingebetteten elektronischen Bauteilen werden mittels Durchkontaktierungen 27 (Microvias, Vias) in einem Leiterplatten-Standardprozess miteinander verbunden und sichern die elektrischen Verbindungen in der Z-Achse der kompakten Baugruppe.

Eine derart ausgebildete Leiterplattenstruktur 17 zeichnet sich gegenüber dem Stand der Technik neben der verbesserten Miniaturisierung auch durch kleineren Energieverbrauch und geringere Verlustleistung aus. Vorliegend umfasst die Leiterplattenstruktur 17 mehrere voneinander isoliert angeordnete Leiterplatten 33 mit eingebetteten Elementen, wie dem Mikrocontroller 29 und dem Drucksensor 30, welche hier lediglich als Beispiele für weitere äquivalent ausgestattete Ausführungsformen stehen sollen; typischerweise sind die hier horizontal und somit senkrecht zur Z-Achse angeordneten Leiterplatten 33 von Isolationsfüllungen 32 beabstandet, wobei Leiterbahnen bzw. Durchkontaktierungen 27 teilweise oder vollständig die Leiterplattenstruktur 17 elektrisch verbinden.

Vorliegend weist die Leiterplattenstruktur 17 eine Kavität 41 mit dem innenliegenden Drucksensor 30 auf, wobei dieser Drucksensor 30 vollständig von der Kavität 41 umgeben ist, mit Ausnahme der direkten, auch elektrischen Verbindung zwischen dem Drucksensor 30 und der Leiterplatte 33. Die Kavität 41 weist eine Öffnung 50 auf, womit der Drucksensor 30 ausserhalb der Kavität 41 mit dem Luftstrom in den Luftkanälen 39a, 39b der elektrischen Zigarette 1 in Wirkverbindung tritt, siehe auch Fig. 1. Durch die Tatsache, dass der Drucksensor 30 lediglich mit der Leiterplatte 33 verbunden ist und ansonsten berührungsfrei in der Kavität 41 angeordnet ist, können thermische und/oder mechanische Einflüsse auf den Drucksensor -beispielsweise seitens der Isolationsfüllung 32- weitgehend vermieden werden.

Mit besonderem Vorteil ist die Steuereinheit 5b als eine solche Leiterplattenstruktur 17 ausgebildet, wobei der Drucksensor 30 unmittelbar mit dem Luftkanal 39, 39a bzw. 39b in Wirkverbindung steht, siehe auch Fig. 1, um beim Ansaugen über die Mundstücköffnung 18 ein Einschalten der elektrischen Zigarette 1 zu bewirken. Somit kann der Drucksensor 30 in dieser Leiterplattenstruktur 17 als eingebettete, integrierte elektronische Komponente ausgebildet sein.

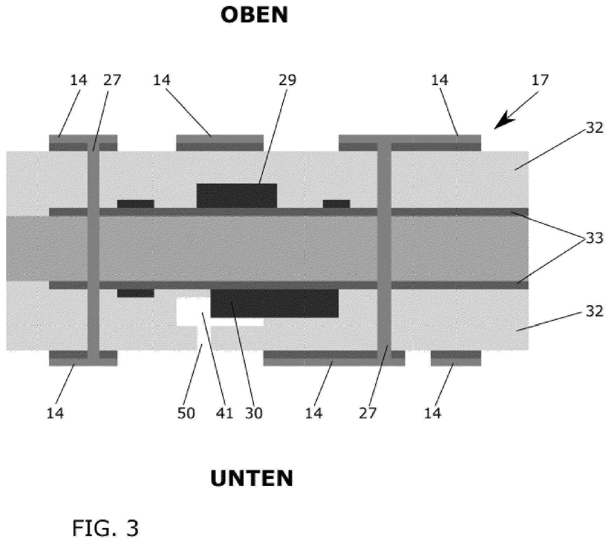

Die weitere Ausführungsform gemäss der Erfindung zeigt in Fig. 3 eine annähernd identische Darstellung wie in der Fig. 2, mit dem Unterschied, dass der Drucksensor 30 neben der Kavität 41 vorliegend partiell zusätzlich von der Isolationsfüllung 32 umgeben ist. Hierbei wird unter Inkaufnahme etwaiger thermischer bzw. mechanischer Einflüsse der Isolationsfüllung 32 auf den Drucksensor 30 eine gegenüber der Ausführungsform in Fig. 2 verbesserte Fixierung des Drucksensors 30 in der Leiterplattenstruktur 17 erzielt. Eine solche Ausgestaltung macht den Drucksensor 30 und damit die gesamte Leiterplattenstruktur 17 unempfindlich gegenüber starken Beschleunigungen, die beispielsweise bei einem Sturz der elektrischen Zigarette auftreten können.

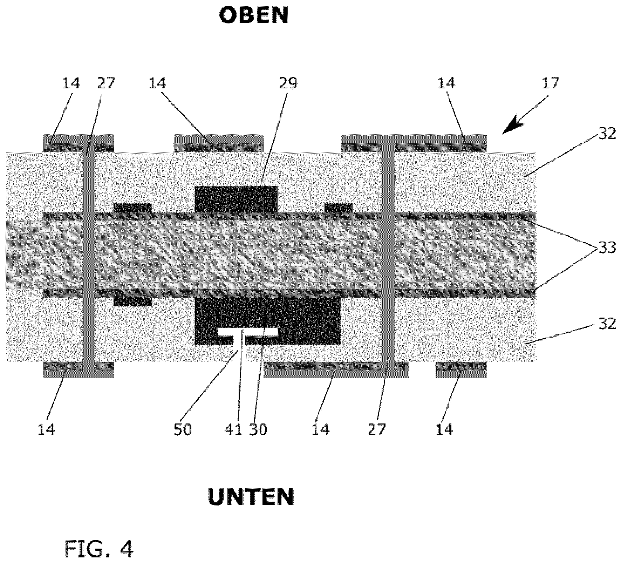

Fig. 4 zeigt eine weitere erfindungsgemässe Ausführungsform, bei welcher im Unterschied zu den Ausführungsformen in den Fig. 2 und 3 die Kavität 41 als ein intrinsischer Bestandteil des Drucksensors 30 ausgeführt ist und der Drucksensor 30 ansonsten vollständig von der Isolationsfüllung 32 umgeben ist. Diese Ausführungsform stellt vergleichsweise die stabilste bzw. gegen Stürze unempfindlichste Ausführungsform der Erfindung dar.

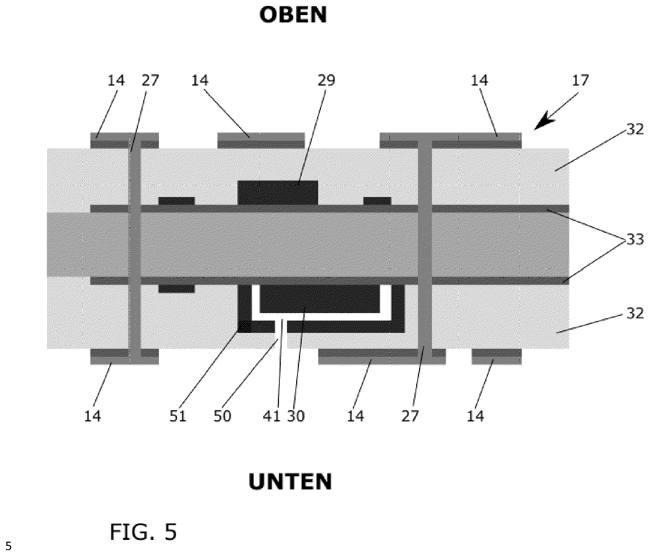

In Fig. 5 ist eine weitere Ausführungsform der Erfindung gezeigt, bei welcher der Drucksensor 30 -in Anlehnung an die Ausführungsform in Fig. 1-vollständig von der Kavität 41 umgeben ist, die selbst von einer Kappe 51 bzw. Haube 51 in der Isolationsfüllung 32 umgeben ist. Diese Kappe 51 kann in einer formstabilen Ausgestaltung bestmöglichen Schutz vor etwaigen Einflüssen der Isolationsfüllung 32 auf den Drucksensor 30 bieten.

### Bezugszeichenliste

- 1: elektrische Zigarette
- 2: Patroneneinheit
- 3: Kontrolleinheit
- 4: Ladespitze
- 5: Steuerelementkörper
- 5a: Ladespitzensteuerung
- 5b: Steuereinheit
- 5c: Patronensteuerung
- 6a, b, c: Körperdurchmesser
- 9: Batteriehülse
- 10: Batterieeinheit
- 11: Aussenröhre der 9, elektrisch nichtleitend
- 12a: Innenröhre der 9, elektrisch leitend
- 12b: Flansch an 12a
- 13a: Batterie
- 13b: Batterieisolierung
- 14, 14a, 14b, 14c, 14d, 14e, 14f, 14g, 14h, 14i, 14j: elektrische Kontaktfläche
- 15: Mantelflächenkontakt
- 16a, 16b: Federkontakt
- 17: Leiterplattenstruktur
- 18: Mundstücköffnung
- 19: Kontaktstift
- 20: Aerosolisierungszone
- 25: Mundstückende
- 27: Durchkontaktierung
- 29: Mikrocontroller
- 30: Sensor, Drucksensor
- 32: Isolationsfüllung
- 33: Leiterplatte
- 35: Patronenabschluss
- 36: Reservoirgehäuse
- 37: Aerosolvorläuferzusammensetzung
- 39, 39a, 39b: Luftkanal
- 41: Kavität in 17
- 42: Mikropumpe
- 43: Nadel
- 44: Zuführer
- 45: Verteiler
- 46: Verteilersubstrat
- 47: Heizchip
- 48: Patronenhülse
- 49: Öffnung in 36
- 50: Öffnung in 32 zur Kavität 41
- 51: Kappe

## Patentansprüche

1. Elektrische Zigarette (1), umfassend eine Patroneneinheit (2) und eine daran lösbar angeordnete Kontrolleinheit (3), wobei die elektrische Zigarette (1) an einem ersten Ende mit einem Mundstückende (25) und an einem zweiten Ende mit einer Ladespitze (4) abschliesst, **dadurch gekennzeichnet, dass** die elektrische Zigarette (1) über deren gesamte Längenausdehnung entlang einer Z-Achse einen zylindrischen oder mehreckigen Querschnitt aufweist und einen ersten und/oder einen zweiten und/oder einen dritten Steuerelementkörper (5) mit einem jeweiligen Körperdurchmesser (6a, 6b, 6c) senkrecht zu der Z-Achse umfasst, wobei dieser jeweilige Körperdurchmesser (6a, 6b, 6c) des jeweiligen Steuerelementkörpers (5) in der elektrischen Zigarette (1) einen Passsitz ausbildet, und wobei der jeweilige Steuerelementkörper (5) ferner als eine Leiterplattenstruktur (17) mit mindestens einer mittels einer Isolationsfüllung (32) isolierten Leiterplatte (33) ausgebildet ist, die quer zur Z-Achse ausgerichtet ist, und wobei auf dieser Leiterplatte (33) mindestens ein Drucksensor (30) angeordnet, der mit einer Kavität (41) in der Leiterplattenstruktur (17) wirkverbunden ist.

2. Elektrische Zigarette (1) gemäss Anspruch 1, **dadurch gekennzeichnet, dass** einer der Steuerelementkörper (5) als eine Steuereinheit (5b) ausgebildet ist, die zwischen der Patroneneinheit (2) und der Kontrolleinheit (3) mit dem Passsitz angeordnet ist und die Kontrolleinheit (3) zu dieser Patroneneinheit (2) hin abschliesst.

3. Elektrische Zigarette (1) gemäss einem der Ansprüche 1 oder 2, **dadurch gekennzeichnet, dass** der mindestens eine Drucksensor (30) mit der mindestens einen Leiterplatte (33) als eine in die Leiterplattenstruktur (17) eingebettete, integrierte elektronische Komponente ausgebildet ist.

4. Elektrische Zigarette (1) gemäss einem der Ansprüche 1 bis 3, **dadurch gekennzeichnet, dass** der Drucksensor (30) auf der Leiterplatte (33) derart angeordnet ist, so dass dieser Drucksensor (30) auf seinen der Leiterplatte (33) abgewandten Seiten vollständig von der Kavität (41) umgeben ist.

5. Elektrische Zigarette (1) gemäss Anspruch 4, **dadurch gekennzeichnet, dass** der Drucksensor (30) auf der Leiterplatte (33) derart angeordnet ist, so dass dieser Drucksensor (30) auf seinen der Leiterplatte (33) abgewandten Seiten vollständig von der Kavität (41) umgeben ist, und wobei die Kavität (41) von einer in der Leiterplattenstruktur (17) eingebetteten Kappe (51) umgeben ist.

6. Elektrische Zigarette (1) gemäss einem der Ansprüche 1 bis 3, **dadurch gekennzeichnet, dass** der Drucksensor (30) auf der Leiterplatte (33) derart angeordnet ist, so dass dieser Drucksensor (30) neben der Kavität (41) partiell von einer Isolationsfüllung (32) umgeben ist.

7. Elektrische Zigarette (1) gemäss einem der Ansprüche 1 bis 3, **dadurch gekennzeichnet, dass** der mindestens eine Drucksensor (30) in der Leiterplattenstruktur (17) die Kavität (41) intrinsisch umfasst.

8. Elektrische Zigarette (1) gemäss einem der vorhergehenden Ansprüche, **dadurch gekennzeichnet, dass** die Kavität (41) mittels einer Öffnung (50) in einer Wirkverbindung mit einem Luftkanal (39, 39a, 39b) in der elektrischen Zigarette (1) steht.

9. Elektrische Zigarette (1) gemäss einem der vorhergehenden Ansprüche, **dadurch gekennzeichnet, dass** der mit der elektrischen Zigarette (1) ausgebildete Passsitz des Steuerelementkörpers (5) als eine Spielpassung ausgebildet ist, wobei der Steuerelementkörper (5) gerade noch leicht verschiebbar angeordnet ist.

10. Elektrische Zigarette (1) gemäss einem der Ansprüche 1 bis 8, **dadurch gekennzeichnet, dass** der mit der elektrischen Zigarette (1) ausgebildete Passsitz des Steuerelementkörpers (5) als eine Übergangspassung ausgebildet ist, wobei der Steuerelementkörper (5) mit geringem Druck verschiebbar angeordnet ist.

## Claims

1. Electronic cigarette (1), comprising a cartridge unit (2) and a control unit (3) removably arranged thereon, the electronic cigarette (1) terminating at a first end with a mouthpiece end (25) and at a second end with a charging tip (4), **characterized in that** the electronic cigarette (1) has a cylindrical or polygonal cross-section over its entire length along a Z-axis and comprises a first and/or a second and/or a third control element body (5) having a respective body diameter (6a, 6b, 6c) perpendicular to the Z-axis, wherein said respective body diameter (6a, 6b, 6c) of the respective control element body (5) forms an interference fit in the electronic cigarette (1), and wherein the respective control element body (5) is further formed as a printed circuit board structure (17) having at least one insulated printed circuit board (33) which is insulated by means of an insulating filling (32) and is aligned transversely to the Z-axis, and at least one pressure sensor (30) being arranged on this printed circuit board (33) and being operatively connected to a cavity (41) in the printed circuit board structure (17).

2. Electronic cigarette (1) according to claim 1, **characterized in that** one of the control element bodies (5) is designed as a control unit (5b) which is arranged with an interference fit between the cartridge unit (2) and the control unit (3) and terminates the control unit (3) towards this cartridge unit (2).

3. Electronic cigarette (1) according to one of claims 1 or 2, **characterized in that** the at least one pressure sensor (30) with the at least one printed circuit board (33) is designed as an integrated electronic component embedded in the printed circuit board structure (17).

4. Electronic cigarette (1) according to one of claims 1 to 3, **characterized in that** the pressure sensor (30) is arranged on the printed circuit board (33) in such a way that this pressure sensor (30) is completely surrounded by the cavity (41) on its sides facing away from the printed circuit board (33).

5. Electronic cigarette (1) according to claim 4, **characterized in that** the pressure sensor (30) is arranged on the printed circuit board (33) in such a way that this pressure sensor (30) is completely surrounded by the cavity (41) on its sides facing away from the printed circuit board (33) side facing away from the printed circuit board (33) is completely surrounded by the cavity (41), and the cavity (41) is surrounded by a cap (51) embedded in the printed circuit board structure (17).

6. Electronic cigarette (1) according to one of claims 1 to 3, **characterized in that** the pressure sensor (30) is arranged on the printed circuit board (33) in such a way that this pressure sensor (30) is partially surrounded by an insulating filling (32) next to the cavity (41).

7. Electronic cigarette (1) according to one of claims 1 to 3, **characterized in that** the at least one pressure sensor (30) in the printed circuit board structure (17) intrinsically encompasses the cavity (41).

8. Electronic cigarette (1) according to one of the preceding claims, **characterized in that** the cavity (41) is operatively connected to an air channel (39, 39a, 39b) in the electronic cigarette (1) by means of an opening (50).

9. Electronic cigarette (1) according to one of the preceding claims, **characterized in that** the snug fit of the control element body (5) formed with the electronic cigarette (1) is designed as a clearance fit, the control element body (5) being arranged such that it can just still be displaced slightly.

10. Electronic cigarette (1) according to one of claims 1 to 8, **characterized in that** the fit of the control element body (5) formed with the electronic cigarette (1) is designed as a transition fit, the control element body (5) being arranged such that it can be displaced with slight pressure.

## Revendications

1. Cigarette électronique (1), comprenant une unité de cartouche (2) et une unité de commande (3) disposée de manière amovible, la cigarette électronique (1) se terminant à une première extrémité par un embout buccal (25) et à une deuxième extrémité par un embout de chargement (4), **caractérisée par le fait que** la cigarette électronique (1) a une section transversale cylindrique ou polygonale sur toute sa longueur le long d'un axe Z et comprend un premier et/ou un deuxième et/ou un troisième corps d'élément de contrôle (5) ayant un diamètre de corps respectif (6a, 6b, 6c) perpendiculaire à l'axe Z, dans lequel ledit diamètre de corps respectif (6a, 6b, 6c) du corps de l'élément de commande respectif (5) forme un ajustement serré dans la cigarette électronique (1), et dans lequel le corps de l'élément de commande respectif (5) est en outre formé d'une structure de carte de circuit imprimé (17) comportant au moins une carte de circuit imprimé isolée (33) qui est isolée au moyen d'un remplissage isolant (32) et est alignée transversalement à l'axe Z, et au moins un capteur de pression (30) étant disposé sur cette carte de circuit imprimé (33) et étant relié de manière opérationnelle à une cavité (41) dans la structure de la carte de circuit imprimé (17).

2. Cigarette électronique (1) selon la revendication 1, **caractérisée par le fait que** l'un des corps de l'élément de commande (5) est conçu comme une unité de commande (5b) qui est disposée avec un ajustement serré entre l'unité de cartouche (2) et l'unité de commande (3) et qui termine l'unité de commande (3) vers cette unité de cartouche (2).

3. Cigarette électronique (1) selon l'une des revendications 1 ou 2, **caractérisée par le fait que** le au moins un capteur de pression (30) avec le au moins un circuit imprimé (33) est conçu comme un composant électronique intégré dans la structure du circuit imprimé (17).

4. Cigarette électronique (1) selon l'une des revendications 1 à 3, **caractérisée par le fait que** le capteur de pression (30) est disposé sur la carte de circuit imprimé (33) de manière à ce que ce capteur de pression (30) soit complètement entouré par la cavité (41) sur ses côtés opposés à la carte de circuit imprimé (33).

5. Cigarette électronique (1) selon la revendication 4, **caractérisée en ce que** le capteur de pression (30) est disposé sur la carte de circuit imprimé (33) de telle sorte que ce capteur de pression (30) est complètement entouré par la cavité (41) sur ses côtés faisant face à l'opposé de la carte de circuit imprimé (33) côté faisant face à l'opposé de la carte de circuit imprimé (33) est complètement entouré par la cavité (41), et la cavité (41) est entourée par un capuchon (51) encastré dans la structure de la carte de circuit imprimé (17).

6. Cigarette électronique (1) selon l'une des revendications 1 à 3, **caractérisée par le fait que** le capteur de pression (30) est disposé sur le circuit imprimé (33) de telle sorte que ce capteur de pression (30) est partiellement entouré d'un remplissage isolant (32) à côté de la cavité (41).

7. Cigarette électronique (1) selon l'une des revendications 1 à 3, **caractérisée par le fait que** le au moins un capteur de pression (30) dans la structure du circuit imprimé (17) englobe intrinsèquement la cavité (41).

8. Cigarette électronique (1) selon l'une des revendications précédentes, **caractérisée par le fait que** la cavité (41) est reliée de manière opérationnelle à un canal d'air (39, 39a, 39b) dans la cigarette électronique (1) au moyen d'une ouverture (50).

9. Cigarette électronique (1) selon l'une des revendications précédentes, **caractérisée par le fait que** l'ajustement serré du corps de l'élément de commande (5) formé avec la cigarette électronique (1) est conçu comme un ajustement de dégagement, le corps de l'élément de commande (5) étant disposé de telle sorte qu'il peut encore être légèrement déplacé.

10. Cigarette électronique (1) selon l'une des revendications 1 à 8, **caractérisée par le fait que** l'ajustement du corps de l'élément de commande (5) formé avec la cigarette électronique (1) est conçu comme un ajustement de transition, le corps de l'élément de commande (5) étant disposé de manière à pouvoir être déplacé avec une légère pression.
